# EUROPEAN PATENT SPECIFICATION

(11) **EP 4 318 129 B1**
(45) Date of publication and mention of the grant of the patent: **06.05.2026**
(21) Application number: 22781603.0
(22) Date of filing: 30.03.2022
(51) Int. Cl.: G03F 7/00, B82Y 40/00

(54) **IMPRINTING DEVICE AND IMPRINTING METHOD**
PRÄGEVORRICHTUNG UND PRÄGEVERFAHREN
DISPOSITIF DE GAUFRAGE ET PROCÉDÉ DE GAUFRAGE

(30) Priority: 30.03.2021 KR 20210041114
(43) Date of publication of application: 07.02.2024
(73) Proprietor: Koh Young Technology Inc., Seoul 08588 (KR); Korea Institute of Machinery & Materials, Daejeon 34103 (KR)
(72) Inventor: LIM, Hyung Jun, Daejeon 34103 (KR); KWON, Soon Geun, Seongnam-si Gyeonggi-do 13525 (KR); CHOI, Hak Jong, Daejeon 34103 (KR); AHN, Jun Hyoung, Daejeon 34061 (KR); KIM, Gee Hong, Daejeon 35249 (KR); CHOI, Kee Bong, Daejeon 34200 (KR); LEE, Jae Jong, Daejeon 34092 (KR)
(74) Representative: Meissner Bolte Partnerschaft mbB
(86) International application number: PCT/KR2022/004495
(87) International publication number: WO 2022/211484

(56) References cited:
- WO-A1-2020/021989
- KR-A- 20090 020 922
- KR-A- 20090 022 190
- KR-A- 20090 070 008
- KR-A- 20090 071 031
- KR-A- 20100 022 817
- KR-A- 20110 063 639
- TW-A- 201 116 401
- US-A1- 2003 159 608
- US-A1- 2021 069 960

## Description

### TECHNICAL FIELD

The present disclosure relates to an imprinting device and an imprinting method.

### BACKGROUND

In the related art, an imprinting device and an imprinting method that perform imprinting on a substrate by irradiating the substrate with ultraviolet rays are known. An imprinting device and an imprinting method have the advantage of being able to produce multiple substrates with a single stamp. Therefore, an imprinting device may be usefully used to manufacture devices with specific functions capable of controlling optical properties, fluid flow, electrical properties, and the like. US 2021/069960 A discloses an imprint apparatus 101 comprising a mold chuck 115 for holding a mold 107, a substrate chuck 119 for holding a substrate 111, an ultraviolet light source 109, and a mold driving mechanism 116 configured to move the mold chuck 115 while holding the mold 107 such as to impress the mold 107 to a resist material 114 on the substrate 111.

An imprinting device in the related art needs to have a chamber that allows for ultraviolet irradiation and is sealed. Accordingly, the shapes that the imprinting device in the related art may have are very limited. In addition, when using an imprinting device in the related art, it may take a lot of processes and time to mount or detach the stamp and the substrate. For example, in order to mount the stamp to form the sealed chamber within the imprinting device, there may be inconvenience of having to additionally attach or detach a cover fixed along an edge of the stamp by a plurality of screws. Accordingly, there may be delays in performing imprinting, and process efficiency may decrease.

### SUMMARY

Embodiments of the present disclosure provide an imprinting device that is capable of quickly and easily performing imprinting.

Embodiments of the present disclosure provide an imprinting method that is capable of being quickly and easily performed.

One aspect of the present disclosure provides embodiments of an imprinting device.

The imprinting device according to a representative embodiment includes: a stamp holder configured such that a stamp is mounted thereon; a substrate holder arranged in a first direction with respect to the stamp holder and configured such that a substrate is mounted thereon; an ultraviolet emitter configured to emit ultraviolet rays toward the substrate mounted on the substrate holder; and a pressing module configured to move at least one of the substrate holder or the stamp holder such that the substrate holder and the stamp mounted on the stamp holder come into contact with each other, wherein the imprinting device is configured to allow the stamp to be mounted on the stamp holder in a state in which the substrate holder and the stamp holder are spaced apart from each other by a predetermined distance or more.

In some embodiments, the imprinting device may further include a support disposed in a first direction with respect to the substrate holder, the support being configured to be brought into contact with and spaced apart from the substrate mounted on the substrate holder and configured to be capable of supporting the substrate mounted on the substrate holder to prevent the substrate from being separated. The imprinting device may be configured to allow the substrate to be mounted on the substrate holder in a state in which the support and the substrate holder are spaced apart from each other.

In some embodiments, the pressing module, the stamp holder, the substrate holder, and the support may be sequentially arranged in the first direction, wherein the pressing module may be configured to be brought into contact with and spaced apart from the stamp holder and configured to press the stamp holder in the first direction, and the pressing module may press the stamp holder in the first direction to move the stamp holder in the first direction so that the stamp mounted on the stamp holder comes into contact with the substrate holder and the substrate holder moves in the first direction to come into contact with the support.

In some embodiments, the pressing module may be configured to be brought into contact with and spaced apart from the stamp holder and configured to press the stamp holder in the first direction, and wherein, in a contact state in which the pressing module, the stamp holder, the stamp mounted on the stamp holder, and the substrate holder are in contact with one another, the stamp, the stamp holder, and the pressing module may be configured to be in close contact with one another to form a chamber space.

In some embodiments, the imprinting device may further includes a pipe configured to guide fluid introduced into the chamber space.

In some embodiments, the pressing module may include a chamber cover configured to be in contact with the stamp holder in the contact state, and the chamber space may be surrounded by the stamp, the stamp holder, and the chamber cover.

In some embodiments, the imprinting device may further includes a sealer located at least one of between the stamp or the stamp holder and between the stamp holder and the chamber cover to prevent fluid in the chamber space from leaking.

In some embodiments, at least one of the stamp holder or the chamber cover may include an elastic portion formed of an elastic material to prevent fluid in the chamber space from leaking.

In some embodiments, the ultraviolet emitter may be disposed in the first direction with respect to the substrate holder so that the ultraviolet rays penetrate the substrate and irradiate contact surfaces between the substrate and the stamp.

In some embodiments, the imprinting device may further include a support disposed in the first direction with respect to the substrate holder and configured to be capable of supporting the substrate holder to prevent the substrate holder from being separated, wherein the ultraviolet emitter may be disposed in the support.

In some embodiments, the ultraviolet emitter may be disposed in a second direction opposite to the first direction with respect to the stamp holder so that the ultraviolet rays penetrate the stamp and irradiate contact surface between the substrate and the stamp.

In some embodiments, the pressing module may be disposed in the second direction with respect to the stamp holder, and wherein the ultraviolet emitter is disposed in the pressing module.

In some embodiments, the ultraviolet emitter may include: a first ultraviolet emitter disposed in the first direction with respect to the substrate holder so that the ultraviolet rays penetrate the substrate and irradiate contact surfaces between the substrate and the stamp; and a second ultraviolet emitter disposed in a second direction opposite to the first direction with respect to the stamp holder so that the ultraviolet rays penetrate the stamp and irradiate the contact surfaces between the substrate and the stamp.

In some embodiments, at least one of the substrate holder or the stamp holder may be configured to rotate or move in a direction transverse to the first direction.

In some embodiments, the imprinting device may further include an optical path guide configured to guide a movement of ultraviolet rays to the ultraviolet emitter.

In some embodiments, the ultraviolet emitter and the optical path guide may be disposed in the pressing module, and the imprinting device may further include a light source located separately outside the pressing module and configured to generate the ultraviolet rays moving along the optical path guide.

In some embodiments, the stamp holder may include a protrusion protruding in a direction facing the stamp mounted on the stamp holder.

A further aspect of the present disclosure provides embodiments of an imprinting device. The imprinting device according to a representative embodiment includes: a stamp holder configured such that a stamp is mounted thereon; a substrate holder arranged in a first direction with respect to the stamp holder and configured such that a substrate is mounted thereon; an ultraviolet emitter configured to emit ultraviolet rays toward the substrate mounted on the substrate holder; a support disposed in a first direction with respect to the substrate holder, the support being configured to be brought into contact with and spaced apart from the substrate mounted on the substrate holder depending on movement of the substrate holder and configured to be capable of supporting the substrate mounted on the substrate holder to prevent the substrate from being separated; and a pressing module configured to move the substrate holder such that the substrate mounted on the substrate holder and the support come into contact with each other, wherein the imprinting device is configured to allow the substrate to be mounted on the substrate holder in a state in which the substrate holder and the support are spaced apart from each other.

A further aspect of the present disclosure provides embodiments of an imprinting method.

The imprinting method according to a representative embodiment includes: mounting a substrate on a substrate holder; mounting a stamp on a stamp holder spaced apart from the substrate holder by a predetermined distance or more; moving, by a pressing module, the stamp holder by coming into contact with the stamp holder so that the substrate holder and the stamp come into contact with each other; introducing fluid into a chamber space formed by the stamp, the stamp holder, and the pressing module which are in close contact with one another in a state in which the substrate holder and the stamp are in contact with each other; and irradiating contact surfaces between the substrate and the stamp with ultraviolet rays in a state in which the stamp is in contact with the substrate by being deformed by pressure of the fluid in the chamber space after the introducing of the fluid.

In some embodiments, the substrate may be a pattern marker, and a pattern may be formed on the pattern marker by the stamp.

In some embodiments, in the mounting of the substrate, the substrate holder may be spaced apart from a support disposed at an opposite side to the stamp holder with respect to the substrate holder, and wherein, in the moving of the stamp holder, the pressing module may come into contact with the stamp holder and the stamp comes into contact with and move the substrate holder such that the support and the substrate mounted on the substrate holder come into contact with each other.

According to an embodiment of the present disclosure, imprinting can be smoothly performed on substrates of various materials and shapes.

According to an embodiment of the present disclosure, the substrate and/or stamp can be easily mounted and detached from the imprinting device, so that imprinting can be performed quickly and easily.

### BRIEF DESCRIPTION OF THE DRAWINGS

FIGS. 1A to 1C are cross-sectional views of an imprinting device according to an example in the related art.
FIGS. 2A to 2C are cross-sectional views of an imprinting device according to another example in the related art.
FIG. 3 is a conceptual cross-sectional view of an imprinting device according to a first embodiment.
FIGS. 4A to 4J are cross-sectional views illustrating shapes of the imprinting device illustrated in FIG. 3 in respective steps in performing an imprinting process.
FIG. 5 is a conceptual cross-sectional view of an imprinting device according to a second embodiment.
FIG. 6 is a cross-sectional view illustrating a shape of the imprinting device illustrated in FIG. 5 in a state in which imprinting is being performed.
FIG. 7 is a conceptual cross-sectional view of an imprinting device according to a third embodiment.
FIG. 8 is a cross-sectional view illustrating a shape of the imprinting device illustrated in FIG. 7 in a state in which imprinting is being performed.
FIG. 9 is a cross-sectional front view of an imprinting device according to a fourth embodiment.
FIG. 10 is a cross-sectional side view of the imprinting device illustrated in FIG. 9.
FIG. 11 is a perspective view of the imprinting device illustrated in FIG. 9 in an aspect.
FIG. 12 is a perspective view of the imprinting device illustrated in FIG. 9 in another aspect.
FIG. 13 is a flowchart of an imprinting method according to an embodiment of the present disclosure.

### DETAILED DESCRIPTION

Embodiments of the present disclosure are exemplified for the purpose of explaining the technical idea of the present disclosure. The scope of the present disclosure is not limited to the embodiments presented below or the detailed descriptions of the embodiments.

In the present disclosure, "embodiments" are arbitrarily divided in order to easily explain the technical idea of the present disclosure, and individual embodiments do not need to be exclusive of each other. For example, configurations disclosed in one embodiment may be applied and implemented in other embodiments, and may be applied and implemented with changes without departing from the scope of the present disclosure.

All technical and scientific terms used in the present disclosure have the meanings generally understood by a person of ordinary skill in the art to which the present disclosure pertains, unless otherwise defined. All terms used in the present disclosure are chosen for the purpose of more clearly explaining the present disclosure and are not chosen to limit the scope of rights according to the present disclosure.

As used in the present disclosure, expressions such as "comprising," "including," and "having" are to be understood as open-ended terms having the possibility of encompassing other embodiments, unless otherwise mentioned in the phrase or sentence containing the corresponding expressions. In addition, terms such as "... part" and "... module" described in the disclosure mean units for processing at least one function or operation, and may be implemented by hardware or software, or by a combination of hardware and software.

Expressions such as "consisting only of" a corresponding configuration used in the present disclosure should be understood as closed-ended terms that exclude the possibility of including other configurations other than the corresponding configuration.

As used in the present disclosure, singular expressions may encompass plural expressions unless otherwise stated, and this also applies to the singular expressions recited in the claims.

Expressions such as "first" and "second" used in the present disclosure are used to distinguish a plurality of elements from each other, and are not intended to limit the order or importance of the corresponding elements.

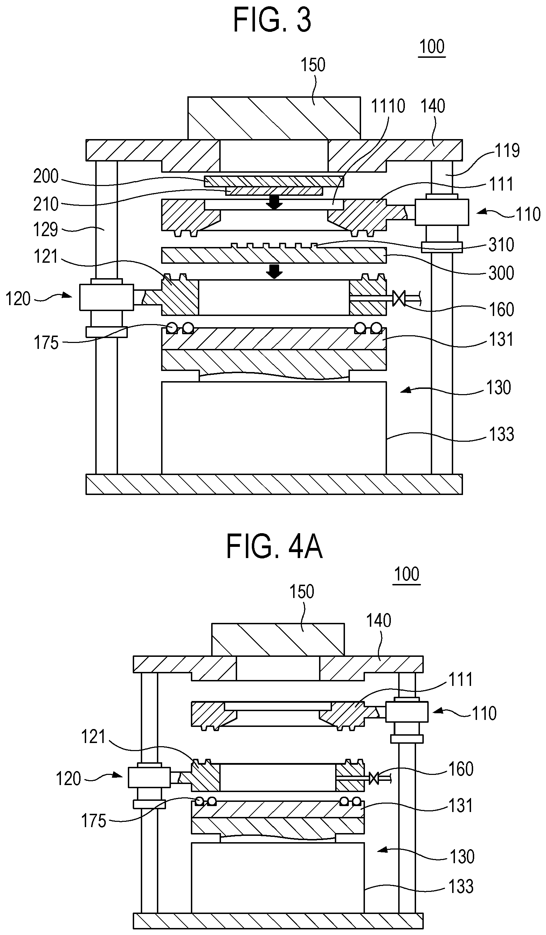

Direction indicators such as "upward" and "upper" used in the present disclosure refer to a direction in which the substrate holder 111 is located with respect to the stamp holder 121 with reference to FIG. 3, and direction indicators such as "downward" and "down" mean an opposite direction to the above-mentioned direction. This is merely a standard for explaining the present disclosure so that the present disclosure can be clearly understood, and of course, the terms "upward" and "downward" may be defined differently depending on where the standard is placed.

Hereinafter, embodiments of the present disclosure will be described with reference to the attached drawings. In the accompanying drawings, identical or corresponding components are assigned the same reference numerals. In addition, in the following description of embodiments, redundant descriptions of the identical or corresponding components may be omitted. However, even if a description of a component is omitted, such a component is not intended to be excluded in an embodiment.

An imprinting set according to an embodiment of the present disclosure includes an imprinting device and a stamp. The stamp may be formed in a shape that can be mounted on the imprinting device. Hereinafter, the imprinting device will be described in detail.

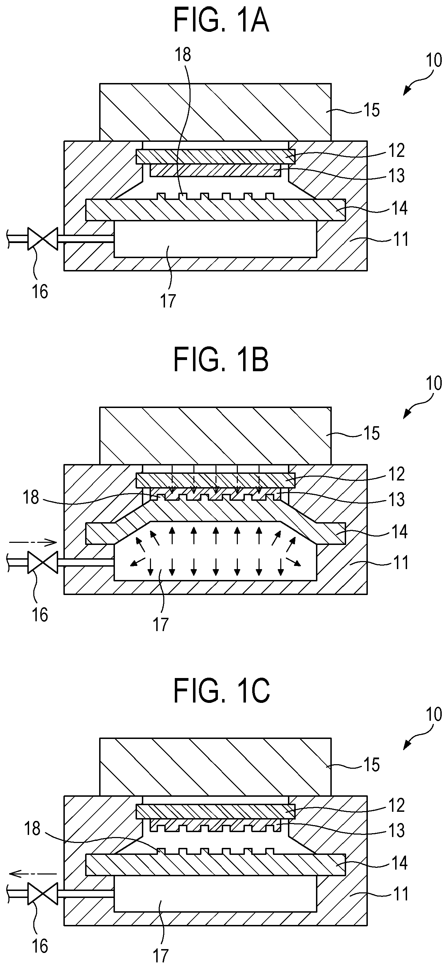

FIGS. 1A to 1C are cross-sectional views of an imprinting device 10 according to an example of the related art, more specifically, an imprinting device 10 in which pneumatic pressure is used and an ultraviolet-irradiating device 15 disposed closer to a substrate 12 than a stamp 14 emits ultraviolet rays to penetrate the substrate 12.

The imprinting device 10 in the related art may include the ultraviolet-irradiating device 15 and a housing 11 in which the substrate 12 and the stamp 14 are mounted. As illustrated in FIG. 1A, the stamp 14 and the substrate 12 may be mounted to be spaced apart from each other by a predetermined distance. Each edge portion of the stamp 14 and the substrate 12 may be mounted in the imprinting device 10 while being fixed by the housing 11 of the imprinting device 10.

A chamber 17 may be formed in the imprinting device 10. The chamber 17 may be a closed space defined by one surface of the stamp 14 and the housing 11 of the imprinting device 10.

Briefly explaining the operation of the imprinting device 10, as illustrated in FIG. 1B, air (or fluid) may be introduced into the chamber 17 through a valve 16. The pressure inside the chamber 17 may rise by a predetermined range or more due to the introduced air. The stamp 14 may be deformed by the pressure in the chamber 17 to expand in the direction in which the chamber 17 expands. Here, the stamp 14 can be deformed to get closer to the substrate 12. Thereafter, the deformed stamp 14 can be brought into contact with the substrate 12 with a certain pressure.

When the stamp 14 and the substrate 12 are in contact with the certain pressure, ultraviolet rays may be emitted from the ultraviolet-irradiating device. The ultraviolet rays emitted from the ultraviolet-irradiating device 15 may penetrate the substrate 12. When the ultraviolet rays are emitted from the ultraviolet-irradiating device 15, a resist 13 applied to the substrate 12 can be cured. A predetermined structure may be formed on the resist 13 by a pattern 18 formed on the stamp 14.

After the resist 13 is cured, the air introduced into the chamber 17 may be exhausted. As illustrated in FIG. 1C, when the air introduced into the chamber 17 is exhausted, the pressure inside the chamber 17 is decreased, and the stamp 14 may be restored to its original shape. The stamp 14 may be returned to its initial position while being restored to its original shape and may be spaced apart from the substrate 12. According to the above-described process, the substrate 12 can be demolded.

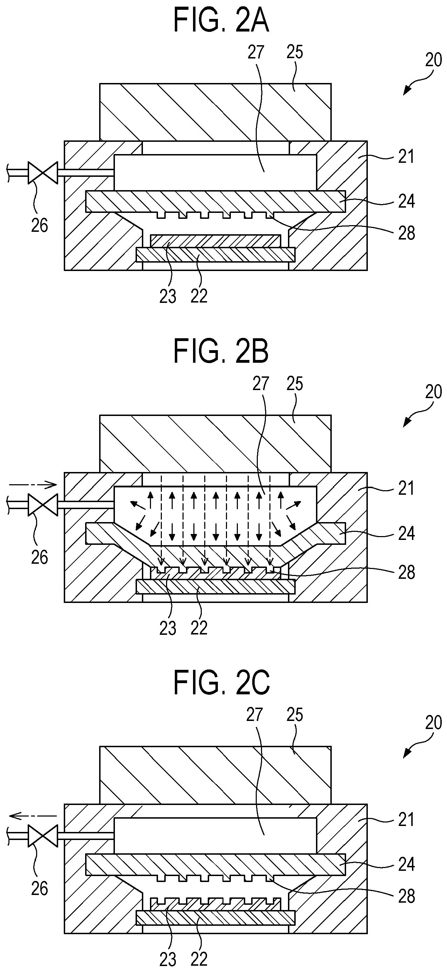

FIGS. 2A to 2C are cross-sectional views of an imprinting device 20 according to another example of the related art, more specifically, an imprinting device 20 in which pneumatic pressure is used and an ultraviolet-irradiating device 25 disposed closer to a stamp 24 than a substrate 22 emits ultraviolet rays to penetrate the stamp 24.

The imprinting device 20 in the related art illustrated in FIGS. 2A to 2C is substantially the same as the imprinting device 10 in the related art illustrated in FIGS. 1A to 1C, except for an arrangement of the ultraviolet-irradiating device 25 and an emission direction of the ultraviolet rays. Hereinafter, the imprinting device 20 will be described by focusing on differences from the imprinting device 10.

When the substrate 12 is transparent, imprinting may be performed with the imprinting device 10 illustrated in FIGS. 1A to 1C, and when the stamp 24 is transparent, imprinting may be performed with the imprinting device 20 illustrated in FIGS. 2A to 2C. When both the substrate 12 or 22 and the stamp 14 or 24 are transparent, imprinting may be performed with either the imprinting device 10 or the imprinting device 20. An order in which the resist 13 or 23 applied to the substrate 12 or 22 is cured may vary depending on the ultraviolet ray irradiation method. Accordingly, the imprinting device 10 or 20 according to the irradiation method may be determined in consideration of the quality of the structure to be formed on the resist 13 or 23.

FIG. 3 is a conceptual cross-sectional view of an imprinting device 100 according to a first embodiment.

Referring to FIG. 3, the imprinting device 100 may include a substrate module 110 including a substrate holder 111. The substrate holder 111 may be configured to be movable in the imprinting device 100. The substrate holder 111 may move along a first direction and a second direction.

The "first direction" referred to in the present disclosure may be understood as any one direction. The "second direction" referred to in the present disclosure is a direction opposite to the "first direction." For example, the first direction may be an upward direction and the second direction may be a downward direction. Of course, the first direction and the second direction are not limited thereto and may be changed to other directions as needed.

The substrate holder 111 may be configured to be rotatable or movable in a direction transverse to the first direction (horizontal direction). As the substrate holder 111 rotates or moves in the horizontal direction, the substrate holder 111 may be operated such that a part or all of the substrate holder 111 is exposed from the imprinting device 100. After the substrate 200 is mounted on the substrate holder 111, the substrate holder 111 may be returned to its original position. Thereby, the substrate 200 may be conveniently mounted on or detached from the substrate holder 111 by a user.

In the present embodiment, the substrate holder 111 may be configured to be rotatable in the horizontal direction in the imprinting device 100. The substrate holder 111 may be rotatable about a predetermined axis (which may be referred to as a "first axis"). The substrate module 110 may include a substrate module shaft 119. The substrate module shaft 119 may be located on the predetermined axis (the first axis). The substrate module shaft 119 may extend in first and second directions. The substrate holder 111 may rotate about the substrate module shaft 119.

In another embodiment (not illustrated), the substrate holder 111 may be configured to be translatable in the horizontal direction. The following description will be based on an embodiment in which the substrate holder 111 rotates, but the present disclosure is not limited thereto.

The substrate holder 111 may be configured to allow a substrate 200 to be mounted thereon. The substrate 200 may be mounted on the substrate holder 111 by being accommodated in a substrate groove 1110 formed in the substrate holder 111. The substrate groove 1110 may have a shape and size corresponding to the substrate 200. The substrate groove 1110 may fix the substrate 200 to prevent the substrate 200 from being separated from the substrate holder 111. The substrate holder 111 may further include additional fixing means to prevent the substrate 200 from being separated.

The substrate 200 mounted on the substrate holder 111 may have various shapes. The substrate 200 may have, for example, a convex or concave lens shape, or may have a shape including both of a concave shape and a convex shape. As an example, the substrate may be a pattern marker to be described later. All the drawings illustrate the substrate 200 having a shape without any curves, but this is for convenience of explanation. The shape of the substrate 200 is not limited by the shape illustrated in the drawings.

The substrate 200 may be mounted on the substrate holder 111 with a resist 210 applied thereon. The resist 210 applied to the substrate 200 may be deformed by an imprinting process. However, the resist 210 is not limited to being applied to the substrate 200, and may be applied to a stamp 300 and then transferred to the substrate 200.

The imprinting device 100 may include a stamp module 120 including a stamp holder 121. The stamp holder 121 may be configured to be movable in the imprinting device 100. For example, the stamp holder 121 may move in the vertical direction.

The stamp holder 121 may be configured to be rotatable or movable in a direction transverse to the first direction (horizontal direction). As the stamp holder 121 rotates or moves in the horizontal direction, the stamp holder 121 may be operated such that a part or all of the stamp holder 121 is exposed from the imprinting device 100. After the stamp 300 is mounted on the stamp holder 121, the stamp holder 121 may be returned to its original position. Thereby, the stamp 300 may be conveniently mounted on or detached from the stamp holder 121 by a user.

In the present embodiment, the stamp holder 121 may be configured to be rotatable in the horizontal direction in the imprinting device 100. The stamp holder 121 may be rotatable about a predetermined axis (which may be referred to as a "second axis"). The stamp module 120 may include a stamp module shaft 129. The stamp module shaft 129 may be located on the predetermined axis (the second axis). The stamp module shaft 129 may extend in the first and second directions. The stamp holder 121 may rotate about the stamp module shaft 129.

In another embodiment (not illustrated), the stamp holder 121 may be configured to be translatable in the horizontal direction. The following description will be based on an embodiment in which the stamp holder 121 rotates, but the present disclosure is not limited thereto.

The stamp holder 121 may be configured to allow the stamp 300 to be mounted thereon. The stamp holder 121 may be disposed in the second direction with respect to the substrate holder 111. The stamp 300 mounted on the stamp holder 121 may be flexible to be bendable or stretchable. At least a portion of the stamp 300 may be made of a flexible elastic material. A predetermined pattern 310 may be formed on a surface of the stamp 300. A size of the pattern 310 may range from several nanometers (nm) to several millimeters (mm). When the stamp 300 and the substrate 200 come into contact with each other, the pattern 310 may deform the resist 210 applied on the substrate 200. For example, when the pattern 310 is concave, the resist 210 may be deformed to be convex, and when the pattern 310 is convex, the resist 210 may be deformed to be concave. That is, the resist 210 can be deformed into a shape that is inverted from the shape of the pattern 310.

The imprinting device 100 may include a pressing module 130 configured to move at least one of the substrate holder 111 or the stamp holder 121. The pressing module 130 may move at least one of the substrate holder 111 or the stamp holder 121 such that the substrate holder 111 and the stamp 300 mounted on the stamp holder 121 come into contact with each other.

As an example, the pressing module 130 may be mounted on at least one of the substrate module 110 or the stamp module 120. For example, the pressing module 130 may be a driving device that is mounted on the substrate module 110 and moves the substrate holder 111, and the driving device may include a motor. In addition, the pressing module 130 may be a driving device that is mounted on the stamp module 120 and moves the stamp holder 121.

As another example, as illustrated in FIG. 3, the pressing module 130 may be configured to press the stamp holder 121 in the direction in which the substrate holder 111 is disposed with respect to the stamp holder 121. The pressing module 130 may include a chamber cover 131 configured to come into contact with the stamp module 120, and a pressing device 133 configured to move the chamber cover 131. The chamber cover 131 may be brought into contact with or spaced apart from the stamp holder 121 depending on ascent or descent of the pressing device 133. However, the structure of the pressing module 130 is not limited by the above description.

The imprinting device 100 includes an ultraviolet-irradiating device (not illustrated) that generates and emits ultraviolet rays. The ultraviolet-irradiating device may include an ultraviolet emitter 150 configured to emit ultraviolet rays toward the substrate 200 mounted on the substrate holder 111. The ultraviolet emitter 150 is an outlet through which ultraviolet rays are emitted from the ultraviolet-irradiating device. The ultraviolet emitter 150 may be arranged to emit ultraviolet rays toward the substrate 200.

The imprinting device 100 may include a support 140 disposed in a first direction with respect to the substrate holder 111. The support 140 may be configured to be brought into contact with and spaced apart from the substrate holder 111. The support 140 may be brought into contact with and spaced apart from the substrate 200 mounted on the substrate holder 111 depending on the movement the substrate holder 111. The support 140 may be configured to be capable of supporting the substrate 200 mounted on the substrate holder 111 to prevent the substrate from being separated from the substrate holder.

Referring to FIG. 3, the pressing module 130, the stamp holder 121, the substrate holder 111, and the support 140 may be sequentially arranged in the first direction. The pressing module 130 may be disposed at the end in the second direction, and the stamp holder 121, the substrate holder 111, and the support 140 may be sequentially arranged from the pressing module 130 in the first direction. In the imprinting device 100 according to the first embodiment, the ultraviolet emitter 150 may be arranged in the first direction with respect to the substrate holder 111 so that ultraviolet rays penetrate the substrate 200 and irradiate contact surfaces between the substrate 200 and the stamp 300. The ultraviolet-irradiating device may be placed on the support 140. The ultraviolet emitter 150 may be disposed on the support 140.

The pressing module 130 may be configured to press the stamp holder 121 in the first direction. The pressing module 130 may be configured to press the stamp holder 121 such that the stamp 300 mounted on the stamp holder 121 is brought into contact with the substrate holder 111. When the pressing module 130 presses the stamp holder 121 in the first direction, the stamp holder 121 moves in the first direction so that the stamp 300 mounted on the stamp holder 121 can be brought into contact with the substrate holder 111, and the substrate holder 111 moves in the first direction so that the substrate holder 111 can be brought into contact with the support 140.

FIGS. 4A to 4J are cross-sectional views illustrating shapes of the imprinting device 100 illustrated in FIG. 3 in respective steps in performing the imprinting process.

The imprinting device 100 may be configured to allow the stamp 300 to be mounted on the stamp holder 121 while the stamp holder 121 and the substrate holder 111 are spaced apart from each other by a predetermined distance (a first predetermined distance) or more. Here, the first predetermined distance may be greater than a vertical thickness of the stamp 300 mounted on the stamp holder 121. In the present embodiment, when the stamp 300 is restrained between the stamp holder 121 and the substrate holder 111, the substrate holder 111 is in contact with the stamp 300 but is not in contact with the stamp holder 121. In this case, the first predetermined distance may be greater than the separation distance between the stamp holder 121 and the substrate holder 111 when the stamp 300 is restrained between the stamp holder 121 and the substrate holder 111 and imprinting is performed. In another embodiment (not illustrated), when the stamp 300 is restrained between the stamp holder 121 and the substrate holder 111, the substrate holder 111 may be in contact with both the stamp 300 and the stamp holder 121. In this case, the first predetermined distance may be a distance between the stamp holder 121 and the substrate holder 111 when the contact between the stamp holder 121 and the substrate holder 111 is released.

The imprinting device 100 may be configured to allow the substrate 200 to be mounted on the substrate holder 111 while the support 140 and the substrate holder 111 are spaced apart from each other. The substrate 200 may be mounted on the substrate holder 111 while the support 140 and the substrate holder 111 are spaced apart from each other by a predetermined distance (a second predetermined distance) or more. In the present embodiment, when the substrate 200 is restrained between the support 140 and the substrate holder 111, the support 140 is in contact with both the substrate 200 and the substrate holder 111. In this case, the second predetermined distance may be a distance between the support 140 and the substrate holder 111 when the contact between the support 140 and the substrate holder 111 is released. In another embodiment (not illustrated), when the substrate 200 is restrained between the support 140 and the substrate holder 111, the support 140 may not be in contact with the substrate holder 111 while being in contact with the substrate 200. In this case, the second predetermined distance may be greater than the separation distance between the support 140 and the substrate holder 111 when the substrate 200 is restrained between the support 140 and the substrate holder 111 and imprinting is performed. Mounting the stamp 300 and mounting the substrate 200 in each step will be described below with reference to FIGS. 4A to 4J.

FIG. 4A is a cross-sectional view illustrating the imprinting device 100 in a standby state. In FIG. 4A, the imprinting device 100 may be in a process standby state in which the substrate 200 and the stamp 300 are not mounted in the imprinting device 100. That is, at the process standby position, the support 140 and the substrate holder 111 may be spaced apart from each other, and the substrate holder 111 and the stamp holder 121 may be spaced apart from each other by a predetermined distance or more. In the standby state illustrated in 4A, the pressing module 130 may be in a state before being operated.

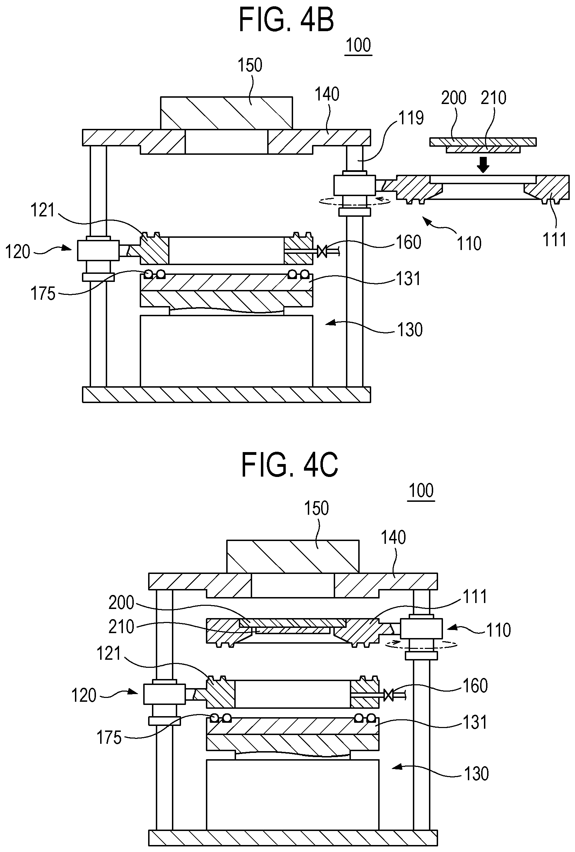

FIG. 4B is a cross-sectional view illustrating the imprinting device 100 in a state in which the substrate holder 111 is rotated. The substrate holder 111 may rotate about the substrate module shaft 119. For example, when viewed from the first direction, the substrate holder 111 may rotate about the substrate module shaft 119 in either a clockwise direction or a counterclockwise direction (a first rotation direction). Since the substrate holder 111 rotates about the substrate module shaft 119, the substrate holder 111 may be exposed to the outside of the imprinting device 100. When the substrate holder 111 is exposed to the outside of the imprinting device 100, a user may easily access the substrate holder 111 and mount the substrate 200 on the substrate holder 111.

FIG. 4C is a cross-sectional view illustrating the imprinting device 100 in a state in which the substrate holder 111 is rotated again after the substrate 200 is mounted on the substrate holder 111. The substrate holder 111 may be located within the imprinting device 100 by rotating in a direction opposite to the rotation direction in FIG. 4B (the first rotation direction). For example, when viewed from the first direction, the substrate holder 111 may rotate about the substrate module shaft 119 in a rotation direction opposite to the first rotation direction and may return to its original position in the imprinting device 100.

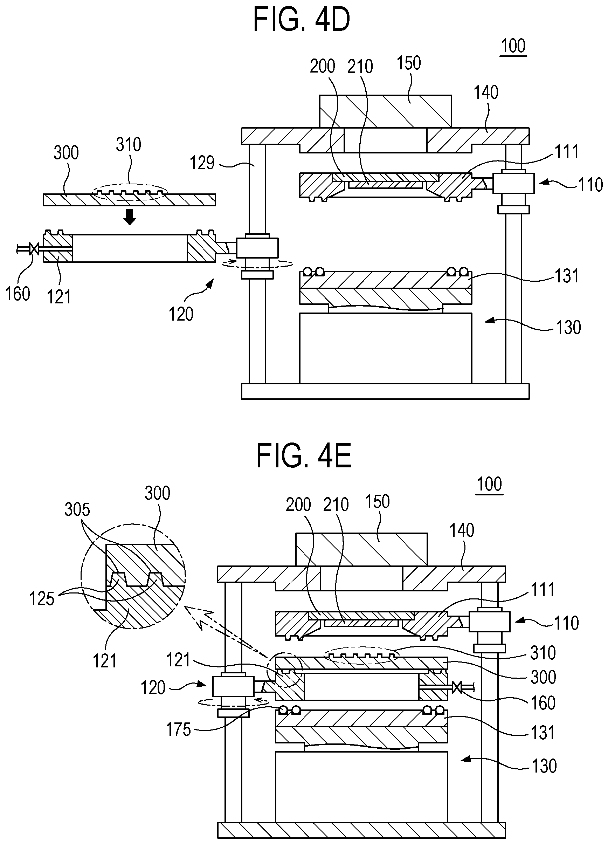

FIG. 4D is a cross-sectional view illustrating the imprinting device 100 in a state in which the stamp holder 121 is rotated. The stamp holder 121 may rotate while the stamp holder 121 and the substrate holder 111 are spaced apart from each other by a predetermined distance or more. The stamp holder 121 may rotate while the stamp holder 121 and the substrate holder 111 are spaced apart from each other by a distance greater than the thickness of the stamp 300.

The stamp holder 121 may rotate about the stamp module shaft 129. For example, when viewed from the first direction, the stamp holder 121 may rotate about the stamp module shaft 129 in either a clockwise direction or a counterclockwise direction (a second rotation direction). Since the stamp holder 121 rotates about the stamp module shaft 129, the stamp holder 121 may be exposed to the outside of the imprinting device 100. When the stamp holder 121 is exposed to the outside of the imprinting device 100, a user may easily access the stamp holder 121 and mount the stamp 300 on the stamp holder 121.

FIG. 4E is a cross-sectional view illustrating the imprinting device 100 in a state in which the stamp older 121 is rotated again after the stamp 300 is mounted on the stamp holder 121. The stamp holder 121 may be located within the imprinting device 100 by rotating in a direction opposite to the rotation direction in FIG. 4D (the second rotation direction). For example, when viewed from the first direction, the stamp holder 121 may rotate about the stamp module shaft 129 in a rotation direction opposite to the second rotation direction and may return to its original position in the imprinting device 100.

Protrusions 125 may be formed on the stamp holder 121 in a direction facing the stamp 300 mounted on the stamp holder 121. Depressions 305 that mesh with the protrusions 125 may be formed in the stamp 300. Accordingly, the stamp 300 may be prevented from being separated from the stamp holder 121. For example, when the stamp 300 is mounted on the stamp holder 121, the stamp 300 may be pressed and deformed by the protrusions 125 to form the depressions 305. In another embodiment (not illustrated), the stamp 300 may have a depression 305 that may mesh with a protrusion 125 even before the stamp 300 is mounted on the stamp holder 121.

FIGS. 4B to 4E illustrates that the substrate holder 111 and the stamp holder 121 rotate by 180 degrees. However, if a part or all of the substrate holder 111 and the stamp holder 121 can be exposed from the imprinting device 100 to sufficiently enable mounting of the substrate 200 and the stamp 300, the rotation angle of the substrate holder 111 and the stamp holder 121 may be set to an angle in a range from 0 degrees to 360 degrees.

In addition, when there is no interference such as collision between the substrate holder 111 and the stamp holder 121 in the process of rotation, the substrate 200 and the stamp 300 may be mounted at the same time.

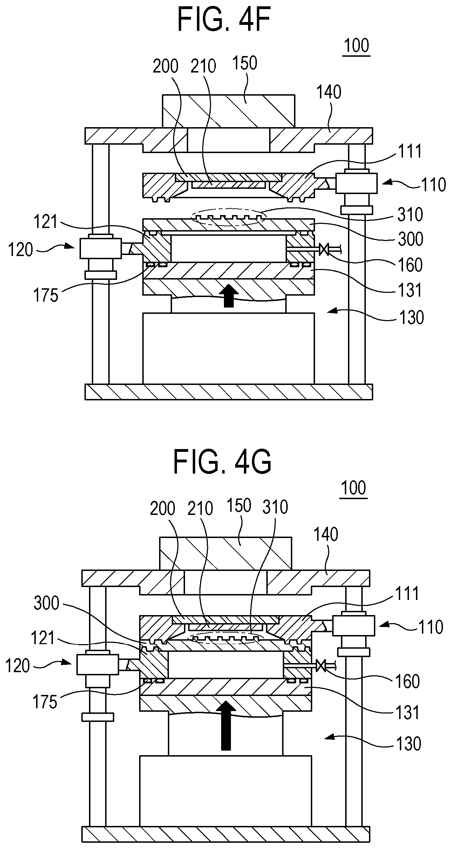

FIGS. 4F to 4I are cross-sectional views in a state in which the pressing module 130 presses the stamp holder 121 in the first direction. As illustrated in FIG. 4F, as the pressing module 130 presses the stamp holder 121 in the first direction, the chamber cover 131 of the pressing module 130 may come into contact with the stamp holder 121. The surface of the chamber cover 131 in the first direction (upward direction) may come into contact with the surface of the stamp holder 121 in the second direction (downward direction).

Thereafter, as illustrated in FIG. 4G, as the pressing module 130 continues to press the stamp holder 121, the stamp holder 121 moves, and the stamp 300 mounted on the stamp holder 121 and the substrate holder 111 may come into contact with each other. The surface of the stamp 300 in the first direction may come into contact with the surface of the substrate holder 111 in the second direction. While the stamp 300 is interposed between the stamp holder 121 and the substrate holder 111, the stamp holder 121 may press the substrate holder 111.

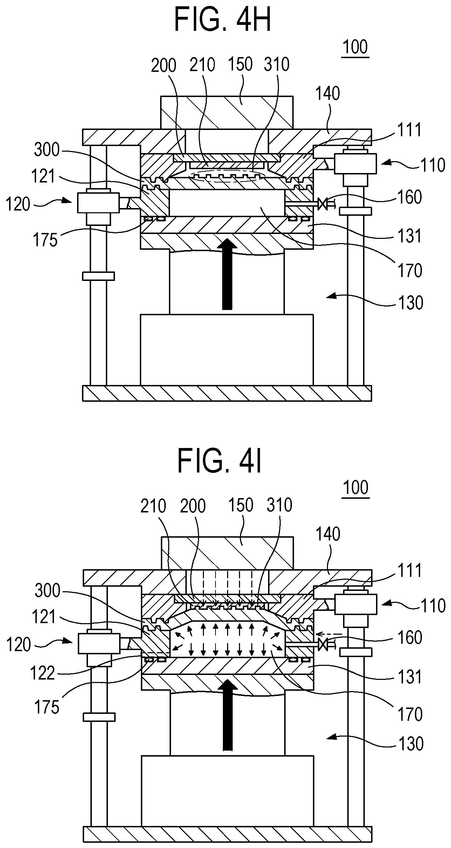

As illustrated in FIG. 4H, as the pressing module 130 continues to press the stamp holder 121, the substrate holder 111 and the support 140 may come into contact with each other. Referring sequentially to FIGS. 4F to 4H, the surface of the chamber cover 131 in the first direction may come into contact with the surface of the stamp holder 121 in the second direction, the surface of the stamp 300, mounted on the stamp holder 121, in the first direction may come into contact with the surface of the substrate holder 111 in the second direction, and the surface of the substrate holder 111 in the first direction may come into contact with the surface of the support 140 in the second direction. The substrate 200 may be restrained between the substrate holder 111 and the support 140, and the stamp 300 may be restrained between the stamp holder 121 and the substrate holder 111 in the first and second directions.

FIGS. 4F to 4H illustrate that the chamber cover 131, the stamp holder 121, the stamp 300, the substrate holder 111, and the support 140 are sequentially brought into contact via the pressing module 130, but each of the above-described components may be configured to be sealed non-sequentially or simultaneously.

In the state in which the pressing module 130, the stamp holder 121, the stamp 300 mounted on the stamp holder 121, and the substrate holder 111 are in contact with one another, the stamp 300, the stamp holder 121, and the pressing module 130 may be in close contact with one another to form a chamber space 170. The chamber space 170 may be surrounded by the stamp 300, the stamp holder 121, and the chamber cover 131. The chamber space 170 may be a sealed space and may have a predetermined volume or more.

As illustrated in FIG. 4I, fluid may be introduced into the chamber space 170. The imprinting device 100 may include a pipe 160 configured to guide the fluid introduced into the chamber space 170. The pipe 160 may be located in the stamp holder 121 and may extend into the chamber space 170. However, a number and a location of the pipe 160 are not limited to this, and various modifications are possible, such as installing a plurality of pipes as needed or installing the pipe 160 in the chamber cover 131.

The imprinting device 100 may include a sealer 175 to prevent the fluid in the chamber space 170 from leaking. The sealer 175 may be located at least one of between the stamp 300 and the stamp holder 121 or between the stamp holder 121 and the chamber cover 131. FIGS. 4A to 4I illustrate that the sealer 175 is located between the stamp holder 121 and the chamber cover 131, but locations and numbers of sealers 175 are not limited thereto. The sealer 175 may be made of an elastic material. The elastic material of the sealer 175 located between the stamp 300 and the stamp holder 121 may have a smaller elastic modulus than that of the stamp holder 121. The elastic material of the sealer 175 located between the stamp holder 121 and the chamber cover 131 may have a smaller elastic modulus than that of the chamber cover 131. The elastic material may be, for example, silicone, rubber, plastic, or the like. The sealer 175 may have, for example, an O-ring shape. However, a material and a shape of the sealer 175 are not limited thereto.

At least one of the stamp holder 121 or the chamber cover 131 may include an elastic portion 122 made of an elastic material. FIG. 4I illustrates that the elastic portion 122 is a portion of the stamp holder 121, but locations and numbers of elastic portions 122 are not limited thereto. For example, when the elastic portion is a portion of the stamp holder 121, the elastic portion may be a portion located in at least one of a portion where the stamp holder 121 is in contact with the stamp 300 or a portion where the stamp holder 121 is in contact with the chamber cover 131. When the elastic portion is a portion of the chamber cover 131, the elastic portion may be a portion where the chamber cover 131 is in contact with the stamp holder 121. In an embodiment in which the elastic portion 122 is a portion of the stamp holder 121, the elastic material of the elastic portion 122 may have a small elastic modulus compared to other portions of the stamp holder 121. In an embodiment in which the elastic portion is a portion of the chamber cover 131, the elastic material of the elastic portion may have a lower elastic modulus than other portions of the chamber cover 131. The elastic material may be, for example, silicone, rubber, plastic, or the like.

The elastic portion 122 may ensure that the stamp 300, the stamp holder 121, and the chamber cover 131 are hermetically sealed to one another. Since the chamber space 170 is hermetically sealed, when the fluid is introduced into the chamber space 170, a pressure inside the chamber space 170 may increase to a predetermined range or higher.

When an upward presssing force by the pressing module 130 is insufficient according to formation of the pressure inside the chamber space 170, there is a high possibility that the air inside the chamber space 170 will leak. Thus, it is obvious to a person of ordinary skill in the art that the upward pressing force by pressing module 130 should be set to be greater than a force by the pressure inside the chamber space 170 that pushes the chamber cover 131 downward.

The pressure of the chamber space 170 may rise to a predetermined range or higher, the stamp 300 may be deformed to expand in a direction in which the chamber space 170 expands, and the deformed stamp 300 may come into contact with the substrate 200 with a predetermined pressure. When the stamp 300 and the substrate 200 come into contact with each other with a certain pressure, ultraviolet rays may be emitted from the ultraviolet-irradiating device toward the substrate 200. When ultraviolet rays are emitted from the ultraviolet-irradiating device, the resist 210 applied to the substrate 200 may be cured.

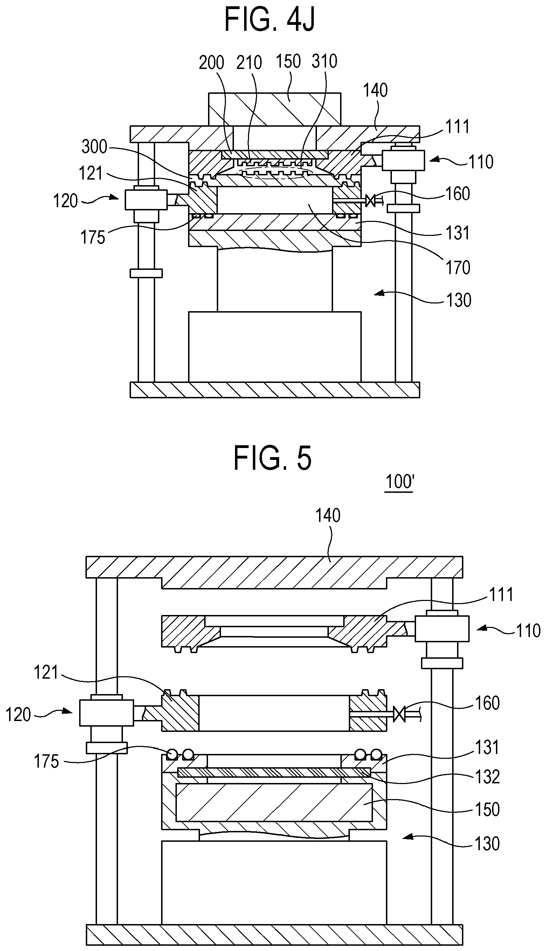

After the resist 210 is cured, the air introduced into the chamber space 170 may be exhausted. As illustrated in FIG. 4J, when the air introduced into the chamber space 170 is exhausted, the pressure inside the chamber space 170 is decreased, and the stamp 300 may be restored to its original shape. As a result, the stamp 300 may be returned to its initial position while being restored to its original shape, and may be spaced apart from the substrate 200. After performing the imprinting process, steps of exhausting the air from the chamber and detaching the substrate 200 and stamp 300 may be performed in the reverse order of the above-described process.

The substrate 200 that can be manufactured by the imprinting device 100 may be, for example, a pattern marker (not illustrated) which is a component of an optical tracking system. The optical tracking system may be utilized, for example, to track an object in real time in equipment such as a surgical robot. For example, an optical tracking system may include at least one marker attached to an object and cameras that image light reflected by the marker, and may mathematically calculate information acquired from the cameras to acquire information of position and/or posture of the object.

The pattern marker manufactured by the imprinting device 100 may have a predetermined pattern. The pattern may be formed on the pattern marker by the stamp 300. The user may change the pattern of the pattern marker by changing a type of the stamp 300. The pattern marker manufactured by the imprinting device 100 may have various shapes. The pattern marker may be a curved pattern marker having a curved shape or a ball marker having a ball shape, but is not limited thereto.

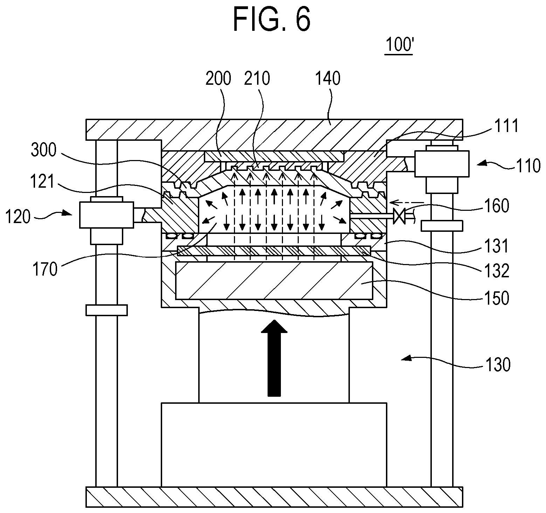

FIG. 5 is a conceptual cross-sectional view of an imprinting device 100' according to a second embodiment. FIG. 6 is a cross-sectional view illustrating the shape of the imprinting device 100' illustrated in FIG. 5 in an imprinting state. Hereinafter, the imprinting device 100' according to the second embodiment will be described by focusing on differences from the imprinting device 100 according to the first embodiment.

Referring to FIGS. 5 and 6, the ultraviolet emitter 150 of the imprinting device 100' may be disposed in the second direction with respect to the stamp holder 121 so that ultraviolet rays penetrate the stamp 300 and irradiate contact surfaces between the substrate 200 and the stamp 300.

The ultraviolet-irradiating device of the imprinting device 100' may be disposed in the second direction of the stamp holder 121. The ultraviolet emitter 150 of the imprinting device 100' may be disposed in the pressing module 130. In an embodiment in which the ultraviolet emitter 150 is disposed in the pressing module 130, a portion of the chamber cover 131 of the pressing module 130 may be a transparent portion 132. Ultraviolet rays emitted from the ultraviolet emitter 150 may penetrate the transparent portion 132 and the stamp 300, and contact surfaces between the substrate 200 and the stamp 300 may be irradiated with the ultraviolet rays.

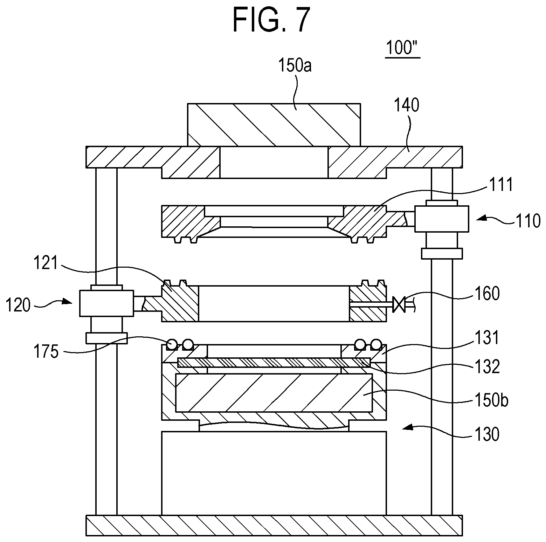

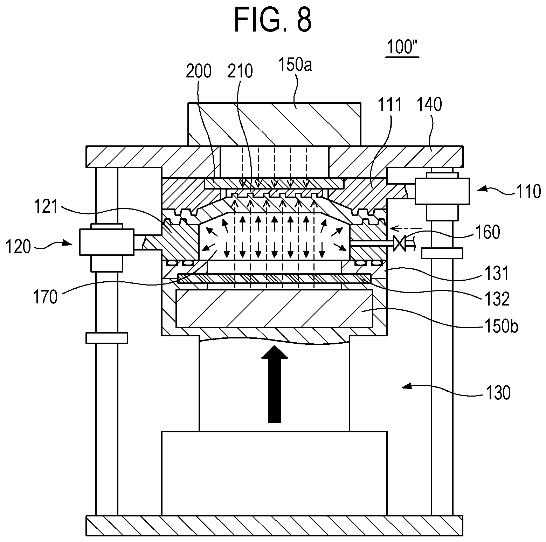

FIG. 7 is a conceptual cross-sectional view of an imprinting device 100" according to a third embodiment. FIG. 8 is a cross-sectional view illustrating a shape of the imprinting device 100" illustrated in FIG. 7 in an imprinting state. Hereinafter, the imprinting device 100" according to the third embodiment will be described by focusing on differences from the imprinting device 100 according to the first embodiment.

Referring to FIGS. 7 and 8, the ultraviolet emitter 150 of the imprinting device 100" may include a first ultraviolet emitter 150a and a second ultraviolet emitter 150b. The first ultraviolet emitter 150a may be configured to emit ultraviolet rays in the second direction, and the second ultraviolet emitter 150b may be configured to emit ultraviolet rays in the first direction.

The first ultraviolet emitter 150a may be disposed in the first direction with respect to the substrate holder 111 so that ultraviolet rays penetrate the substrate 200 and irradiate contact surfaces between the substrate 200 and the stamp 300. The first ultraviolet emitter 150a may be disposed in the support 140.

The second ultraviolet emitter 150b may be disposed in the second direction with respect to the stamp holder 121 so that ultraviolet rays penetrate the stamp 300 and irradiate the contact surfaces between the substrate 200 and the stamp 300. The second ultraviolet emitter 150b may be disposed in the pressing module 130.

According to the third embodiment, the ultraviolet irradiation may be performed in a direction toward the substrate, toward the stamp, or toward both the substrate and the stamp. A user may select the direction of the ultraviolet irradiation based on the materials, shapes, and properties of the substrate and the stamp. Therefore, imprinting can be effectively performed on a substrate and a stamp containing various materials.

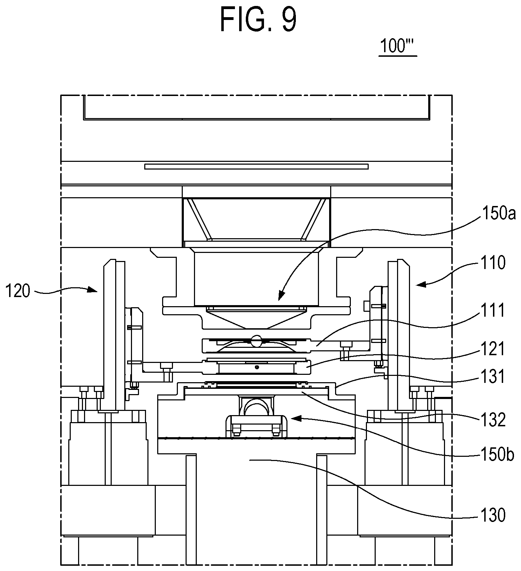

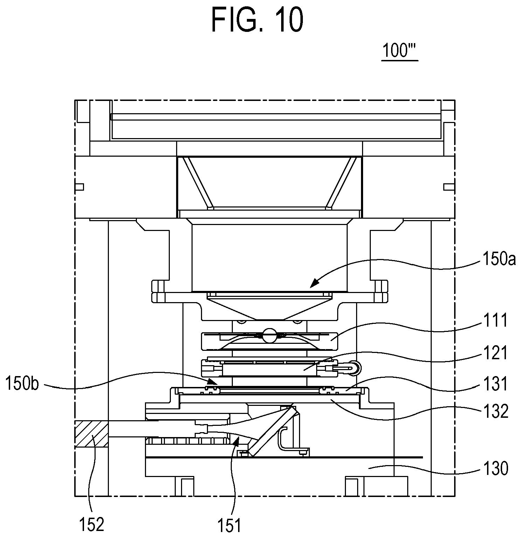

FIG. 9 is a cross-sectional front view of an imprinting device 100‴ according to a fourth embodiment. FIG. 10 is a cross-sectional side view of the imprinting device 100‴ illustrated in FIG. 9. Hereinafter, the imprinting device 100‴ according to the fourth embodiment will be described by focusing on differences from the above-described embodiments.

Referring to FIGS. 9 and 10, the ultraviolet emitter 150 of the imprinting device 100‴ may include a first ultraviolet emitter 150a and a second ultraviolet emitter 150b. The ultraviolet-irradiating device of the imprinting device 100‴ may include an optical path guide 151 configured to guide a movement of ultraviolet rays to at least one of the first ultraviolet emitter 150a or the second ultraviolet emitter 150b. As an example, the optical path guide 151 may be disposed in the pressing module 130. The optical path guide 151 may include at least one of an optical fiber or a reflective mirror. Ultraviolet rays generated from a light source, which will be described later, may be guided to an ultraviolet emitter along the optical path guide 151 and then emitted to the substrate mounted on the substrate holder 111 by the ultraviolet emitter. As an example, ultraviolet rays generated from a light source, which will be described later, may be guided to the second optical path guide 150b along the optical path guide 151. FIG. 10 illustrates that the optical path guide 151 is disposed in the pressing module 130 and connected to the second ultraviolet emitter 150b. However, without being limited thereto, the imprinting device 100‴ may further include an additional optical path guide, which is connected to the first ultraviolet emitter 150a.

The ultraviolet-irradiating device of the imprinting device 100‴ may include a light source 152 that generates ultraviolet rays. The ultraviolet-irradiating device of the imprinting device 100‴ may include a shutter (not illustrated) configured to control ultraviolet irradiation of the light source 152, a cooling device (not illustrated) configured to cool the light source 152, and/or an optical component such as a lens (not illustrated) to increase efficiency and improve quality.

In the imprinting device 100‴, the ultraviolet emitter 150 and the optical path guide 151 are located within the pressing module 130, and the light source 152, the shutter, the cooling device, and the optical component such as a lens may be included outside the pressing module 130. Accordingly, a size and a weight of the pressing module 130 can be reduced, which may be advantageous in space utilization, and a load, which may occur when the pressing module 130 operates, can be reduced.

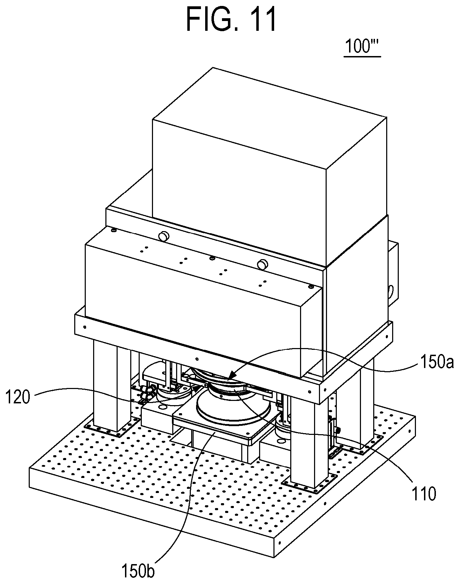

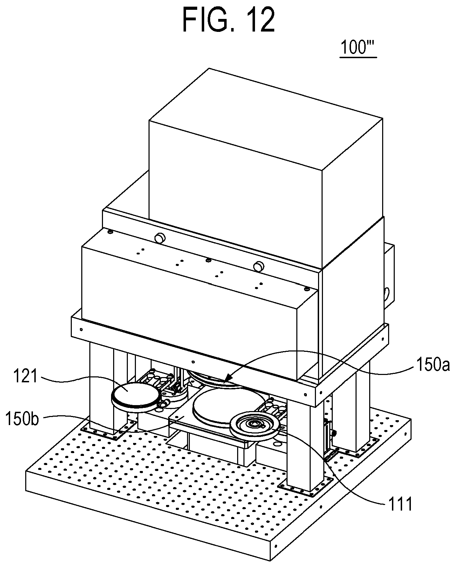

FIG. 11 is a perspective view of the imprinting device 100‴ illustrated in FIG. 9 in an aspect. FIG. 12 is a perspective view of the imprinting device 100‴ illustrated in FIG. 9 in another aspect.

The imprinting device 100‴ according to the fourth embodiment may be changed from the aspect illustrated in FIG. 11 to the other aspect illustrated in FIG. 12 or from the other aspect illustrated in FIG. 12 to the aspect illustrated in FIG. 11. In the aspect illustrated in FIG. 11, the imprinting device 100‴ is capable of performing imprinting. In the other aspect illustrated in FIG. 12, at least one of a substrate 200 or a stamp 300 may be mounted on and detached from the imprinting device 100"'.

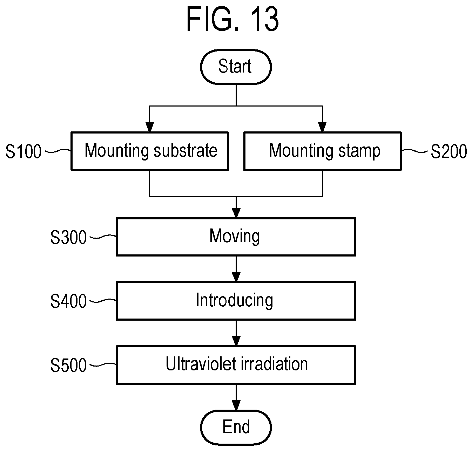

FIG. 13 is a flowchart of an imprinting method according to an embodiment of the present disclosure. The imprinting method may be performed by using an imprinting device according to one of the above-described embodiments, but an embodiment of this disclosure is not limited thereto.

Although process steps, method steps, algorithms, and the like are illustrated in a sequential order in the flow chart of FIG. 13, such processes, methods, and algorithms may be configured to operate in any suitable order. In other words, the steps of the processes, methods, and algorithms described in various embodiments of the present disclosure need not be performed in the order described in various embodiments of the present disclosure. In addition, although some steps are described as being performed non-simultaneously, in other embodiments, the some steps may be performed simultaneously. In addition, exemplification of a process in a drawing does not imply that the exemplified process excludes any changes and modifications thereto, that the exemplified process or any of steps thereof are essential to one or more of the various embodiments of the present disclosure, or that the exemplified process is desirable.

Referring to FIG. 13, the imprinting method may include a substrate mounting step (S100) of mounting a substrate on the substrate holder. The imprinting method may include a stamp mounting step (S200) of mounting a stamp on the stamp holder. According to an embodiment, one of the substrate mounting step (S100) and the stamp mounting step (S200) may be performed prior to the other, or both steps may be performed simultaneously.

In the stamp mounting step (S200), the stamp holder may be spaced apart from the substrate holder. In the substrate mounting step (S100), the substrate holder may be spaced apart from the support disposed at an opposite side of the stamp holder with respect to the substrate holder. In the substrate mounting step (S100), the substrate holder may be spaced apart from both the stamp holder and the support.

The imprinting method may include a moving step (S300) of moving at least one of the substrate module or the stamp holder. The moving step (S300) may be performed after the substrate mounting step (S100) and the stamp mounting step (S200). In the moving step (S300), the pressing module may operate such that the substrate holder and the stamp mounted on the stamp holder come into contact with each other.

In the moving step (S300), the pressing module may move the stamp holder. In the moving step (S300), the pressing module may come into contact with the stamp holder to move the stamp holder. In the moving step (S300), the pressing module may come into contact with the stamp holder to move the stamp holder, and the stamp mounted on the stamp holder may come into contact with the substrate holder to move the substrate holder. Thereafter, the substrate holder may come into contact with the support. The pressing module, the stamp holder, the stamp mounted on the stamp holder, the substrate holder, and the support may come into contact sequentially.

The imprinting method may include an introducing step (S400) of introducing fluid into a chamber space. The introducing step (S400) may proceed after the moving step (S300). In the introducing step (S400), the stamp, the stamp holder, and the pressing module may be in close contact with one another to form the chamber space while the substrate holder and the stamp holder are in contact with each other.

The imprinting method may include an ultraviolet irradiation step (S500) of irradiating contact surfaces between the substrate and the stamp with ultraviolet rays. The ultraviolet irradiation step (S500) may be performed after the introducing step (S400). In the ultraviolet ray irradiation step (S500), ultraviolet irradiation may be performed in the state in which the stamp mounted on the stamp holder is deformed to be in contact with the substrate by the pressure of the fluid in the chamber space.

The technical idea of the present disclosure has been described heretofore with reference to some embodiments and examples illustrated in the accompanying drawings. However, it is to be understood that various substitutions, modifications and alterations may be made without departing from the scope of the present disclosure that can be understood by a person of ordinary skill in the technical field to which the present disclosure pertains. In addition, such substitutions, modifications, and alterations are to be considered as falling within the scope of the appended claims.

## Claims

1. An imprinting device (100, 100', 100", 100‴) comprising:
a stamp holder (121) configured such that a stamp (300) is mounted thereon;
a substrate holder (111) arranged in a first direction with respect to the stamp holder (121) and configured such that a substrate (200) is mounted thereon;
an ultraviolet emitter (150) configured to emit ultraviolet rays toward the substrate (200) mounted on the substrate holder (111); and
a pressing module (130) configured to move at least one of the substrate holder (111) or the stamp holder (121),
wherein the imprinting device (100, 100', 100", 100‴) is configured to allow the stamp (300) to be mounted on the stamp holder (121) in a state in which the substrate holder (111) and the stamp holder (121) are spaced apart from each other by a predetermined distance or
more, **characterized in that**
the pressing module (130) is configured to move the at least one of the substrate holder (111) or the stamp holder (121) such that the substrate holder (111) and the stamp (300) mounted on the stamp holder (121) come into contact with each other.

2. The imprinting device (100, 100', 100", 100‴) of Claim 1, further comprising:
a support (140) disposed in the first direction with respect to the substrate holder (111), the support (140) being configured to be brought into contact with and spaced apart from the substrate (200) mounted on the substrate holder (111) and configured to be capable of supporting the substrate (200) mounted on the substrate holder (111) to prevent the substrate (200) from being separated,
wherein the imprinting device (100, 100', 100", 100‴) is configured to allow the substrate (200) to be mounted on the substrate holder (111) in a state in which the support (140) and the substrate holder (111) are spaced apart from each other.

3. The imprinting device (100, 100', 100", 100‴) of Claim 2, wherein the pressing module (130), the stamp holder (121), the substrate holder (111), and the support (140) are sequentially arranged in the first direction,
wherein the pressing module (130) is configured to be brought into contact with and spaced apart from the stamp holder (121) and configured to press the stamp holder (121) in the first direction, and
wherein the pressing module (130) presses the stamp holder (121) in the first direction to move the stamp holder (121) in the first direction so that the stamp (300) mounted on the stamp holder (121) comes into contact with the substrate holder (111) and the substrate holder (111) moves in the first direction to come into contact with the support (140).

4. The imprinting device (100, 100', 100", 100"') of Claim 1, wherein the pressing module (130) is configured to be brought into contact with and spaced apart from the stamp holder (121) and configured to press the stamp holder (121) in the first direction, and
wherein, in a contact state in which the pressing module (130), the stamp holder (121), the stamp (300) mounted on the stamp holder (121), and the substrate holder (111) are in contact with one another, the stamp, the stamp holder (121), and the pressing module (130) are configured to be in close contact with one another to form a chamber space (170).

5. The imprinting device of (100, 100', 100", 100"') Claim 4, wherein the pressing module (130) comprises a chamber cover (131) configured to be in contact with the stamp holder (121) in the contact state, and
wherein the chamber space (170) is surrounded by the stamp (300), the stamp holder (121), and the chamber cover (131).

6. The imprinting device (100, 100', 100", 100"') of Claim 5, wherein at least one of the stamp holder (121) or the chamber cover (131) comprises an elastic portion (122) formed of an elastic material to prevent fluid in the chamber space (170) from leaking.

7. The imprinting device (100, 100", 100"') of Claim 1, wherein the ultraviolet emitter (150) is disposed in the first direction with respect to the substrate holder (111) so that the ultraviolet rays penetrate the substrate (200) and irradiate contact surfaces between the substrate (200) and the stamp (300).

8. The imprinting device (100', 100", 100‴) of Claim 1, wherein the ultraviolet emitter (150) is disposed in a second direction opposite to the first direction with respect to the stamp holder (121) so that the ultraviolet rays penetrate the stamp (300) and irradiate contact surface between the substrate (200) and the stamp (300).

9. The imprinting device (100', 100", 100‴) of Claim 8, wherein the pressing module (130) is disposed in the second direction with respect to the stamp holder (121), and
wherein the ultraviolet emitter (150) is disposed in the pressing module (130).

10. The imprinting device (100", 100‴) of Claim 1, wherein the ultraviolet emitter (150) comprises:
a first ultraviolet emitter (150a) disposed in the first direction with respect to the substrate holder (111) so that the ultraviolet rays penetrate the substrate (200) and irradiate contact surfaces between the substrate (200) and the stamp (300); and
a second ultraviolet emitter (150b) disposed in a second direction opposite to the first direction with respect to the stamp holder (121) so that the ultraviolet rays penetrate the stamp (300) and irradiate the contact surfaces between the substrate (200) and the stamp (300).

11. The imprinting device (100, 100', 100", 100‴) of Claim 1, wherein at least one of the substrate holder (111) or the stamp holder (121) is configured to rotate or move in a direction transverse to the first direction.

12. The imprinting device (100‴) of Claim 1, further comprising:
an optical path guide (151) configured to guide a movement of ultraviolet rays to the ultraviolet emitter (150).

13. The imprinting device (100‴) of Claim 12, wherein the ultraviolet emitter (150) and the optical path guide (151) are disposed in the pressing module (130), and
wherein the imprinting device (100) further comprises a light source (152) located separately outside the pressing module (130) and configured to generate the ultraviolet rays moving along the optical path guide (151).

14. An imprinting method comprising:
mounting a substrate on a substrate holder (S100);
mounting a stamp on a stamp holder spaced apart from the substrate holder by a predetermined distance or more (S200);
moving, by a pressing module, the stamp holder by coming into contact with the stamp holder so that the substrate holder and the stamp come into contact with each other (S300);
introducing fluid into a chamber space formed by the stamp, the stamp holder, and the pressing module which are in close contact with one another in a state in which the substrate holder and the stamp are in contact with each other (S400); and
irradiating contact surfaces between the substrate and the stamp with ultraviolet rays in a state in which the stamp is in contact with the substrate by being deformed by pressure of the fluid in the chamber space after the introducing of the fluid (S500).

15. The imprinting method of Claim 14, wherein, in the mounting of the substrate (S100), the substrate holder is spaced apart from a support disposed at an opposite side to the stamp holder with respect to the substrate holder, and
wherein, in the moving of the stamp holder (S300), the pressing module comes into contact with the stamp holder and the stamp comes into contact with and moves the substrate holder such that the support and the substrate mounted on the substrate holder come into contact with each other.

## Patentansprüche

1. Prägevorrichtung (100, 100', 100", 100"'), umfassend:
einen Stempelhalter (121), der derart konfiguriert ist, dass ein Stempel (300) daran montiert ist;
einen Substrathalter (111), der im Verhältnis zum Stempelhalter (121) in einer ersten Richtung eingerichtet und derart konfiguriert ist, dass ein Substrat (200) daran montiert ist;
einen ultravioletten Strahler (150), der dazu konfiguriert ist, ultraviolette Strahlen in Richtung auf das Substrat (200), das an dem Substrathalter (111) montiert ist, auszustrahlen; und
ein Pressmodul (130), das dazu konfiguriert ist, mindestens einen von dem Substrathalter (111) oder dem Stempelhalter (121), zu bewegen,
wobei die Prägevorrichtung (100, 100', 100", 100"') dazu konfiguriert ist, zu ermöglichen, dass der Stempel (300) an dem Stempelhalter (121) in einem Zustand, in dem der Substrathalter (111) und der Stempelhalter (121) in einem vorbestimmten Abstand oder mehr voneinander beabstandet sind, montiert wird,
**dadurch gekennzeichnet, dass** das Pressmodul (130) dazu konfiguriert ist, den mindestens einen von dem Substrathalter (111) oder dem Stempelhalter (121) derart zu bewegen, dass der Substrathalter (111) und der Stempel (300), der an dem Stempelhalter (121) montiert ist, miteinander in Kontakt kommen.

2. Prägevorrichtung (100, 100', 100", 100"') nach Anspruch 1, ferner umfassend:
einen Träger (140), der im Verhältnis zu dem Substrathalter in der ersten Richtung (111) angeordnet ist, wobei der Träger (140) dazu konfiguriert ist, mit dem Substrat (200), das an dem Substrathalter (111) montiert ist, in Kontakt gebracht und davon beabstandet zu werden, und dazu konfiguriert ist, das Substrat (200), das an dem Substrathalter (111) montiert ist, tragen zu können, um zu verhindern, dass sich das Substrat (200) trennt,
wobei die Prägevorrichtung (100, 100', 100", 100"') dazu konfiguriert ist, zu ermöglichen, dass das Substrat (200) an dem Substrathalter (111) in einem Zustand, in dem der Träger (140) und der Substrathalter (111) voneinander beabstandet sind, montiert wird.

3. Prägevorrichtung (100, 100', 100", 100"') nach Anspruch 2, wobei das Pressmodul (130), der Stempelhalter (121), der Substrathalter (111) und der Träger (140) der Reihe nach in der ersten Richtung eingerichtet sind,
wobei das Pressmodul (130) dazu konfiguriert ist, mit dem Stempelhalter (121) in Kontakt gebracht und davon beabstandet zu werden, und dazu konfiguriert ist, den Stempelhalter (121) in die erste Richtung zu drücken, und
wobei das Pressmodul (130) den Stempelhalter (121) in die erste Richtung drückt, um den Stempelhalter (121) in die erste Richtung derart zu bewegen, dass der Stempel (300), der an dem Stempelhalter (121) montiert ist, mit dem Substrathalter (111) in Kontakt kommt, und sich der Substrathalter (111) in die erste Richtung bewegt, um mit dem Träger (140) in Kontakt zu kommen.

4. Prägevorrichtung (100, 100', 100", 100"') nach Anspruch 1, wobei das Pressmodul (130) dazu konfiguriert ist, mit dem Stempelhalter (121) in Kontakt gebracht und davon beabstandet zu werden, und dazu konfiguriert ist, den Stempelhalter (121) in die erste Richtung zu drücken, und
wobei, in einem Kontaktzustand, in dem das Pressmodul (130), der Stempelhalter (121), der Stempel (300), der an dem Stempelhalter (121) montiert ist, und der Substrathalter (111) miteinander in Kontakt stehen, der Stempel, der Stempelhalter (121) und das Pressmodul (130) dazu konfiguriert sind, in engem Kontakt zueinander zu stehen, um einen Kammerraum (170) zu bilden.

5. Prägevorrichtung von (100, 100', 100", 100"') nach Anspruch 4, wobei das Pressmodul (130) eine Kammerabdeckung (131) umfasst, die dazu konfiguriert ist, mit dem Stempelhalter (121) im Kontaktzustand in Kontakt zu stehen, und
wobei der Kammerraum (170) von dem Stempel (300), dem Stempelhalter (121) und der Kammerabdeckung (131) umgeben ist.

6. Prägevorrichtung (100, 100', 100", 100"') nach Anspruch 5, wobei mindestens einer von dem Stempelhalter (121) oder der Kammerabdeckung (131) einen elastischen Abschnitt (122) umfasst, der aus einem elastischen Material gebildet ist, um zu verhindern, dass das Fluid in dem Kammerraum (170) ausläuft.

7. Prägevorrichtung (100, 100", 100"') nach Anspruch 1, wobei der ultraviolette Strahler (150) im Verhältnis zu dem Substrathalter (111) in der ersten Richtung derart angeordnet ist, dass die ultravioletten Strahlen in das Substrat (200) eindringen und die Kontaktflächen zwischen dem Substrat (200) und dem Stempel (300) bestrahlen.

8. Prägevorrichtung (100', 100", 100"') nach Anspruch 1, wobei der ultraviolette Strahler (150) im Verhältnis zu dem Stempelhalter (121) in einer zweiten Richtung, die zu der ersten Richtung entgegengesetzt ist derart angeordnet ist, dass die ultravioletten Strahlen in den Stempel (300) eindringen und die Kontaktfläche zwischen dem Substrat (200) und dem Stempel (300) bestrahlen.

9. Prägevorrichtung (100', 100", 100"') nach Anspruch 8, wobei das Pressmodul (130) im Verhältnis zu dem Stempelhalter (121) in der zweiten Richtung angeordnet ist, und
wobei der ultraviolette Strahler (150) in dem Pressmodul (130) angeordnet ist.

10. Prägevorrichtung (100", 100"') nach Anspruch 1, wobei der ultraviolette Strahler (150) umfasst:
einen ersten ultravioletten Strahler (150a), der im Verhältnis zu dem Substrathalter (111) in der ersten Richtung derart angeordnet ist, dass die ultravioletten Strahlen in das Substrat (200) eindringen und die Kontaktflächen zwischen dem Substrat (200) und dem Stempel (300) bestrahlen; und
einen zweiten ultravioletten Strahler (150b), im Verhältnis zu dem Stempelhalter (121) der in einer zweiten Richtung, die zu der ersten Richtung entgegengesetzt ist, derart angeordnet ist, dass die ultravioletten Strahlen in den Stempel (300) eindringen und die Kontaktflächen zwischen dem Substrat (200) und dem Stempel (300) bestrahlen.

11. Prägevorrichtung (100, 100', 100", 100"') nach Anspruch 1, wobei mindestens einer von dem Substrathalter (111) oder dem Stempelhalter (121) dazu konfiguriert ist, sich in einer Richtung, die zu der ersten Richtung querliegt, zu drehen oder zu bewegen.

12. Prägevorrichtung (100"') nach Anspruch 1, ferner umfassend:
einen Lichtwegleiter (151), der dazu konfiguriert ist, eine Bewegung von ultravioletten Strahlen zu dem ultravioletten Strahler (150) zu leiten.

13. Prägevorrichtung (100"') nach Anspruch 12, wobei der ultraviolette Strahler (150) und der Lichtwegleiter (151) in dem Pressmodul (130) angeordnet sind, und
wobei die Prägevorrichtung (100) ferner eine Lichtquelle (152) umfasst, die sich getrennt außerhalb des Pressmoduls (130) befindet und dazu konfiguriert ist, die ultravioletten Strahlen zu generieren, die sich entlang des Lichtwegleiters (151) bewegen.

14. Prägeverfahren umfassend:
Montieren eines Substrats an einem Substrathalter (S100);
Montieren eines Stempels an einem Stempelhalter, der von dem Substrathalter in einem vorbestimmten Abstand oder mehr beabstandet ist (S200);
Bewegen, durch ein Pressmodul, des Stempelhalters durch In-Kontakt-Kommen mit dem Stempelhalter, so dass der Substrathalter und der Stempel miteinander in Kontakt kommen (S300);
Einführen von Fluid in einen Kammerraum, der durch den Stempel, den Stempelhalter und das Pressmodul, die in engem Kontakt miteinander stehen, in einem Zustand, in dem der Substrathalter und der Stempel miteinander in Kontakt stehen, gebildet wird (S400); und
Bestrahlen der Kontaktflächen zwischen dem Substrat und dem Stempel mit ultravioletten Strahlen in einem Zustand, in dem der Stempel mit dem Substrat in Kontakt steht, indem er sich durch den Druck des Fluids in dem Kammerraum nach dem Einführen des Fluids verformt (S500).

15. Prägeverfahren nach Anspruch 14, wobei beim Montieren des Substrats (S100) der Substrathalter von einem Träger beabstandet wird, der auf einer gegenüberliegenden Seite zum Stempelhalter im Verhältnis zu dem Substrathalter angeordnet ist, und
wobei bei dem Bewegen des Stempelhalters (S300) das Pressmodul mit dem Stempelhalter in Kontakt kommt, und der Stempel mit dem Substrathalter in Kontakt kommt und diesen bewegt, so dass der Träger und das Substrat, das an dem Substrathalter montiert ist, miteinander in Kontakt kommen.

## Revendications

1. Dispositif de gaufrage (100, 100', 100", 100‴) comprenant :
un porte-empreinte (121) configuré de telle sorte qu'une empreinte (300) y est montée ;
un porte-substrat (111) agencé dans une première direction par rapport au porte-empreinte (121) et configuré de telle sorte qu'un substrat (200) y est monté ;
un émetteur d'ultraviolet (150) configuré pour émettre des rayons ultraviolets vers le substrat (200) monté sur le porte-substrat (111) ; et
un module de pressage (130) configuré pour déplacer au moins un élément parmi le porte-substrat (111) et le porte-empreinte (121),
dans lequel le dispositif de gaufrage (100, 100', 100", 100‴) est configuré pour permettre le montage de l'empreinte (300) sur le porte-empreinte (121) dans un état où le porte-substrat (111) et le porte-empreinte (121) sont espacés l'un de l'autre d'une distance prédéterminée ou plus,
**caractérisé en ce que** le module de pressage (130) est configuré pour déplacer ledit au moins un élément parmi le porte-substrat (111) et le porte-empreinte (121) de sorte que le porte-substrat (111) et l'empreinte (300) montée sur le porte-empreinte (121) entrent en contact l'un avec l'autre.

2. Dispositif de gaufrage (100, 100', 100", 100‴) selon la revendication 1, comprenant en outre :
un support (140) disposé dans la première direction par rapport au porte-substrat (111), le support (140) étant configuré pour être mis en contact avec le substrat (200) monté sur le porte-substrat (111) et espacé dudit substrat, et configuré pour être capable de supporter le substrat (200) monté sur le porte-substrat (111) afin d'empêcher une séparation du substrat (200),
dans lequel le dispositif de gaufrage (100, 100', 100", 100‴) est configuré pour permettre au substrat (200) d'être monté sur le porte-substrat (111) dans un état où le support (140) et le porte-substrat (111) sont espacés l'un de l'autre.

3. Dispositif de gaufrage (100, 100', 100", 100‴) selon la revendication 2, dans lequel le module de pressage (130), le porte-empreinte (121), le porte-substrat (111) et le support (140) sont agencés séquentiellement dans la première direction,
dans lequel le module de pressage (130) est configuré pour être espacé et mis en contact avec le porte-empreinte (121), et configuré pour presser le porte-empreinte (121) dans la première direction, et
dans lequel le module de pressage (130) presse le porte-empreinte (121) dans la première direction pour déplacer le porte-empreinte (121) dans la première direction afin que l'empreinte (300) montée sur le porte-empreinte (121) entre en contact avec le porte-substrat (111) et que le porte-substrat (111) se déplace dans la première direction pour entrer en contact avec le support (140).

4. Dispositif de gaufrage (100, 100', 100", 100‴) selon la revendication 1, dans lequel le module de pressage (130) est configuré pour être espacé et mis en contact avec le porte-empreinte (121), et configuré pour presser le porte-empreinte (121) dans la première direction, et
dans lequel, dans un état de contact où le module de pressage (130), le porte-empreinte (121), l'empreinte (300) montée sur le porte-empreinte (121) et le porte-substrat (111) sont en contact les uns avec les autres, l'empreinte, le porte-empreinte (121) et le module de pressage (130) sont configurés pour être en contact étroit les uns avec les autres afin de former un espace de chambre (170).

5. Dispositif de gaufrage (100, 100', 100", 100‴) selon la revendication 4, dans lequel le module de pressage (130) comprend un couvercle de chambre (131) configuré pour être en contact avec le porte-empreinte (121) dans l'état de contact, et
dans lequel l'espace de chambre (170) est entouré par l'empreinte (300), le porte-empreinte (121) et le couvercle de chambre (131).

6. Dispositif de gaufrage (100, 100', 100", 100‴) selon la revendication 5, dans lequel au moins un élément parmi le porte-empreinte (121) et le couvercle de chambre (131) comprend une portion élastique (122) constituée d'un matériau élastique pour empêcher une fuite du fluide présent dans l'espace de chambre (170).

7. Dispositif de gaufrage (100, 100", 100‴) selon la revendication 1, dans lequel l'émetteur d'ultraviolet (150) est disposé dans la première direction par rapport au porte-substrat (111) de sorte que les rayons ultraviolets pénètrent dans le substrat (200) et irradient les surfaces de contact entre le substrat (200) et l'empreinte (300).

8. Dispositif de gaufrage (100', 100", 100‴) selon la revendication 1, dans lequel l'émetteur d'ultraviolet (150) est disposé dans une deuxième direction opposée à la première direction par rapport au porte-empreinte (121) de sorte que les rayons ultraviolets pénètrent dans l'empreinte (300) et irradient la surface de contact entre le substrat (200) et l'empreinte (300).

9. Dispositif de gaufrage (100', 100", 100‴) selon la revendication 8, dans lequel le module de pressage (130) est disposé dans la deuxième direction par rapport au porte-empreinte (121), et
dans lequel l'émetteur d'ultraviolet (150) est disposé dans le module de pressage (130).

10. Dispositif de gaufrage (100", 100‴) selon la revendication 1, dans lequel l'émetteur d'ultraviolet (150) comprend :
un premier émetteur d'ultraviolet (150a) disposé dans la première direction par rapport au porte-substrat (111) de sorte que les rayons ultraviolets pénètrent dans le substrat (200) et irradient les surfaces de contact entre le substrat (200) et l'empreinte (300) ; et
un deuxième émetteur d'ultraviolet (150b) disposé dans une deuxième direction opposée à la première direction par rapport au porte-empreinte (121) de sorte que les rayons ultraviolets pénètrent dans l'empreinte (300) et irradient les surfaces de contact entre le substrat (200) et l'empreinte (300).

11. Dispositif de gaufrage (100, 100', 100", 100‴) selon la revendication 1, dans lequel au moins un élément parmi le porte-substrat (111) et le porte-empreinte (121) est configuré pour tourner ou se déplacer dans une direction transversale à la première direction.

12. Dispositif de gaufrage (100‴) selon la revendication 1, comprenant en outre :
un guide de chemin optique (151) configuré pour guider le déplacement des rayons ultraviolets vers l'émetteur d'ultraviolet (150).

13. Dispositif de gaufrage (100‴) selon la revendication 12, dans lequel l'émetteur d'ultraviolet (150) et le guide de chemin optique (151) sont disposés dans le module de pressage (130), et
dans lequel le dispositif de gaufrage (100) comprend en outre une source de lumière (152) située séparément à l'extérieur du module de pressage (130) et configurée pour générer les rayons ultraviolets qui se déplacent le long du guide de chemin optique (151).

14. Procédé de gaufrage comprenant :
le montage d'un substrat sur un porte-substrat (S100) ;-;
le montage d'une empreinte sur un porte-empreinte espacé du porte-substrat d'une distance prédéterminée ou plus (S200) ;
le déplacement, par un module de pressage, du porte-empreinte en entrant en contact avec le porte-empreinte de sorte que le porte-substrat et l'empreinte entrent en contact l'un avec l'autre (S300) ;
l'introduction de fluide dans un espace de chambre formé par l'empreinte, le porte-empreinte et le module de pressage, qui sont en contact étroit les uns avec les autres dans un état où le porte-substrat et l'empreinte sont en contact l'un avec l'autre (S400) ; et
l'irradiation des surfaces de contact entre le substrat et l'empreinte avec des rayons ultraviolets dans un état où l'empreinte est en contact avec le substrat en étant déformée par la pression du fluide dans l'espace de chambre après l'introduction du fluide (S500).

15. Procédé de gaufrage selon la revendication 14, dans lequel, lors du montage du substrat (S100), le porte-substrat est espacé d'un support disposé du côté opposé au porte-empreinte par rapport au porte-substrat, et
dans lequel, lors du déplacement du porte-empreinte (S300), le module de pressage entre en contact avec le porte-empreinte, et l'empreinte entre en contact avec le porte-substrat et déplace celui-ci de sorte que le support et le substrat monté sur le porte-substrat entrent en contact l'un avec l'autre.
